# EUROPÄISCHE PATENTANMELDUNG

(11) **EP 1 102 316 A1**
(43) Veröffentlichungstag der Anmeldung: **23.05.2001**
(21) Anmeldenummer: 99122772.9
(22) Anmeldetag: 16.11.1999
(51) Int. Cl.: H01L 23/538, G06K 19/077

(54) **Multi-Chip IC-Karte mit Bus-Struktur**

(71) Anmelder: Infineon Technologies AG, 81669 München (DE)
(72) Erfinder: Pueschner, Frank, 93309 Kehlheim (DE); Riedel, Jens, 93049 Regensburg (DE)
(74) Vertreter: Hermann, Uwe, Dipl.-Ing.

(57) **Zusammenfassung**

Multi-Chip-Modul, insbesondere zur Implantation in einen Chipkartenkörper, mit einem Trägerband und einer oder mehreren auf dem Trägerband nebeneinander aufgebrachten Chipgruppen, die einen oder mehrere übereinander gestapelte und parallel geschaltete Chips enthalten, bei dem mehrere bustaugliche Chipgruppen innerhalb des Multi-Chipmoduls flächig parallel geschaltet werden können.

## Beschreibung

Die Erfindung betrifft ein Multi-Chipmodul nach dem Oberbegriff des Anspruchs 1.

Chipmodule mit einem auf einem Trägersubstrat angeordneten Chip werden grundsätzlich überall dort eingesetzt, wo es darauf ankommt, eine Erleichterung der Kontaktierung des Chips von außen mit gegenüber den Chipanschlußflächen stark vergrößerten elektrischen Leitern zu ermöglichen.

Derartige Chipmodule werden beispielsweise in Chipkarten eingesetzt und ermöglichen über die freiliegend auf der Kartenoberfläche angeordneten Anschlußkontakte, die üblicherweise den ISO-Standards 7810 oder 7816 entsprechen, eine "äußere Kontaktierung" des auf der Rückseite des Moduls im Inneren der Chipkarte befindlichen Chips. Im folgenden wird diese Art von Chipkarte als kontaktbehaftete Chipkarte bezeichnet.

Desweiteren werden derartige Chipmodule auch zum Aufbau sogenannter kontaktloser Chipkarten verwendet, bei denen die Anschlußleiter des Moduls zur erleichterten Kontaktierung mit einer im Inneren des Kartenkörpers angeordneten Antennenspule dienen.

Natürlich lassen sich derartige Chipmodule auch zum Aufbau einer sogenannten Kombi-Chipkarte benutzen, bei der sowohl eine äußere Kontaktierung für einen kontaktbehafteten Zugriff als auch eine innere Kontaktierung für einen kontaktlosen Zugriff auf den Chip über die Antennenspule ermöglicht wird.

Zum Schutz des Chips wird üblicherweise ein ihn umgebender, metallischer Versteifungsrahmen auf das Trägersubstrat aufgeklebt und mit einer Masse aufgefüllt, um sowohl Chip als auch Bonddrähte vor mechanischer Beschädigung und optischer Analyse zu schützen.

Ist die Masse, mit der der Chip bedeckt wird, vor dem Aushärten viskos genug, um nicht zu sehr zu zerlaufen, und nach dem Aushärten entsprechend fest und steif, wie zum Beispiel eine Moldmasse, kann der Versteifungsrahmen eingespart werden.

Durch die Kombination des Chips mit dem Trägersubstrat zur Ausbildung eines Chipmoduls entsteht ein im Vergleich zur Stärke des Chips bzw. zur Stärke des Substrats relativ dicker Verbund, der in einem Kartenkörper fest vorgegebener äußerer Abmessungen untergebracht werden muß. Um sich durch die Unterbringung eines Chipmoduls in einem Kartenkörper hinsichtlich der Möglichkeiten weiterer Bauteilinstallationen im Kartenkörper möglichst wenig einschränken zu müssen, erweist es sich daher als wesentlich, das Chipmodul so dünn wie möglich auszuführen.

Ein wesentlicher Nachteil der bekannten, relativ dick ausgeführten Chipmodule besteht darin, daß sie aufgrund ihrer relativ großen Dicke im Vergleich zum flexiblen Kartenkörper eine hohe Biegesteifigkeit aufweisen, so daß es bei der im Alltagsbetrieb häufig auftretenden Biegestreßbelastung des Kartenkörpers zu hohen Beanspruchungen der Verbindung zwischen dem Chipmodul und dem Kartenkörper kommt, was zu einem frühzeitigen Versagen der Verbindung führen kann. Dies gilt in besonderem Maße, wenn sich das Trägersubstrat an der Kartenoberfläche befindet, wie es bei einer Kontaktkarte der Fall ist.

Faßt das Trägersubstrat mehr als einen Chip, spricht man von einem sogenannten Multi-Chipmodul. Derartige Multi-Chipmodule für Chipkarten bestehen üblicherweise aus einem 35 mm Epoxy-Trägerband mit Doppelspur und aufgebrachten Leiterbahnen, das die verschiedenen Chips aufnimmt, wobei die Chips nicht nur in einer Ebene nebeneinander zu liegen kommen, sondern auch übereinander gestapelt werden. Die übereinandergestapelten Chips werden parallel geschaltet (stacking), um Speicher und/oder Funktionsumfang des Moduls zu vergrößern. Diese Technik ist insbesondere dann interessant, wenn eine elektronische Schaltung nur wenig Platz beanspruchen soll, wie es in Chipkartenanwendungen der Fall ist. Allerdings ist die Anzahl der übereinanderliegenden Chips durch die vorgegebenen Dimensionen des Kartenkörpers und aufgrund der sinkenden Elastizität der gesamten Anordnung auf in der Regel zwei Stück stark begrenzt.

Die Parallelschaltung von in einem Multi-Chipmodul nebeneinander liegenden bustauglichen Chiptypen erfolgt erst außerhalb des Moduls und erfordert somit einen zusätzlichen Fertigungsschritt.

Eine Möglichkeit, Speicher und Funktionsumfang eines Multi-Chipmoduls zu vergrößern und gleichzeitig den zusätzlichen Fertigungsschritt der externen Parallelschaltung von im Modul nebeneinanderliegenden bustauglichen Chiptypen einzusparen und somit die Herstellungskosten zu senken, liegt daran, die im Modul nebeneinanderliegenden Chips bereits intern parallel zu schalten.

Der vorliegenden Erfindung liegt die Aufgabe zugrunde, ein Multi-Chipmodul gemäß dem Oberbegriff des Anspruchs 1 derart weiterzubilden, daß die genannten Nachteile möglichst unaufwendig vermieden oder wenigstens verringert werden. Der grundsätzliche Ansatz für die Lösung dieser Aufgabe liegt darin, daß die Parallelschaltung von mehreren bustauglichen Chips in einem Modul nicht nur wie bisher über das sogenannte "stacking", bei dem im Modul übereinander liegende Chips parallel geschaltet werden, sondern auch flächig erfolgen kann. Damit ist gemeint, daß im Modul nebeneinander liegende bustaugliche einzelne Chips oder nebeneinander liegende gestackte Chipgruppen intern parallel geschaltet werden.

Die Möglichkeit zur internen Parallelschaltung der nebeneinander liegenden Chips oder gestackten Chipgruppen bedeutet eine optimale Ausnutzung des standardisierten Trägerbandes und führt zu einer erhöhten Anzahl an Kombinationsmöglichkeiten von bustauglichen Chiptypen innerhalb des Trägerbandes.

Die Erfindung ermöglicht eine größere Flexibilität, insbesondere im Mittelbereich des Moduls, und verringert damit die Gefahr von Beschädigungen bei Biegebeanspruchungen.

Die Lösung dieser Aufgaben erfolgt vorrichtungsmäßig einerseits durch die erfindungsgemäße Änderung des Layouts der auf die Kontaktseite des Multi-Chipmoduls aufzubringenden Leiterbahnen, die zu der erwünschten Parallelschaltung der im selben Modul nebeneinander liegenden Chips oder gestackten Chipgruppen führt.

So kann das Multi-Chipmodul in Zukunft als abgeschlossene Einheit, ohne zusätzliche Fertigungsschritte, produziert werden. Der Fertigungsschritt der externen Parallelschaltung von nebeneinander liegenden Chips oder gestackten Chipgruppen wird eingespart, wodurch die Fertigungskosten sinken.

Andererseits wird durch die Verschmelzung der beiden Mold-Gehäuse auf der 35 mm Epoxy Trägerplatte mit Doppelspur zu einem großen Gehäuse die Stabilität des Moduls zusätzlich gesteigert, wodurch seine mechanische Beanspruchbarkeit wächst.

Die Erfindung wird nachfolgend anhand eines Ausführungsbeispiels einer kontaktbehafteten Chipkarte unter Bezugnahme auf die Zeichnungen näher erleutert.

Darin zeigen
- Fig. 1: eine kontaktbehaftete Chipkarte mit integriertem Multi-Chipmodul,
- Fig. 2: die Chip-Seite eines Multi-Chipmoduls mit zwei nebeneinander liegenden bustauglichen Chips,
- Fig. 3: die Kontaktflächenseite eines Multi-Chipmoduls mit zwei nebeneinander liegenden bustauglichen Chips.

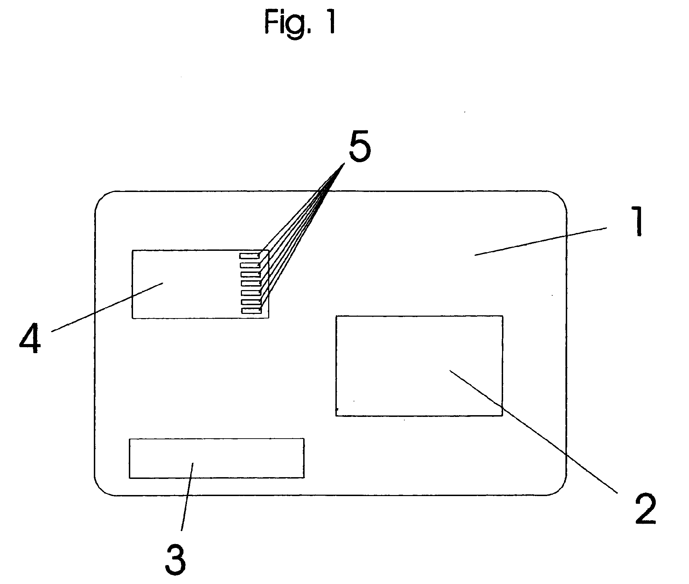

Fig. 1 zeigt als Beispiel einer erfindungsgemäßen Anwendung des Multi-Chipmoduls 4 einen Kartenkörper 1 mit Klarschrift-Datenfeld 2, Unterschriftsstreifen 3, und einem in den Kartenkörper 1 eingebetteten Multi-Chipmodul 4 mit Anschlußkontakten 5.

Der grundsätzliche Aufbau derartiger Karten ist bekannt und soll hier nicht näher erläutert werden. Ferner ist die Art und Weise des Gebrauchs und die Datenverarbeitung in Verbindung mit solchen Karten (insbesondere als Kreditkarten) bekannt.

Über die Anschlußkontakte 5 erfolgt ein Datenaustausch mit beispielsweise einem Terminal, einem Geldausgabeautomaten oder dergleichen.

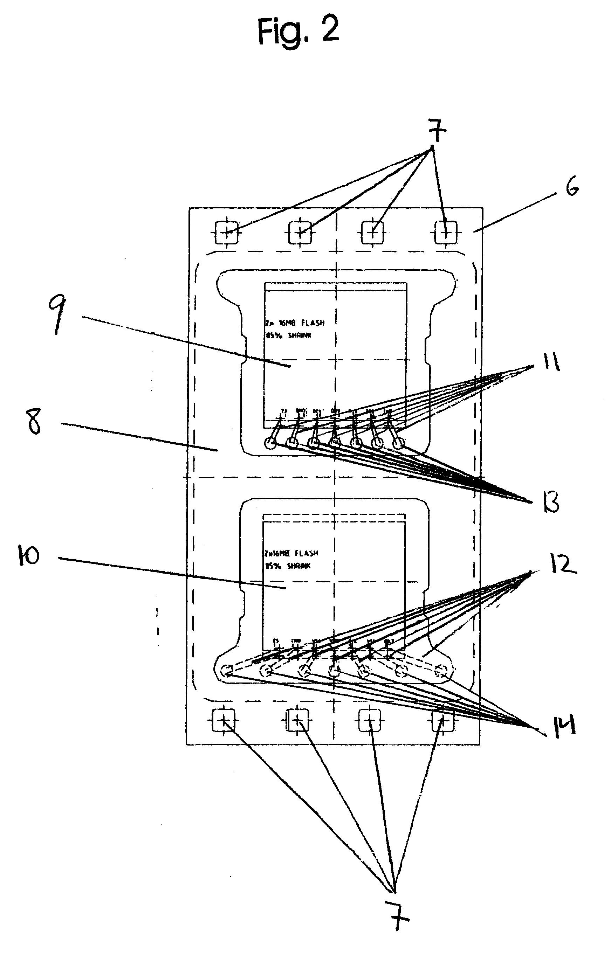

Fig. 2 zeigt im Detail die Chip-Seite des in den Kartenkörper 1 eingebauten Multi-Chipmoduls 4.

Als Träger wird vorzugsweise ein aus einem 35 mm breiten, elektrisch isolierenden Epoxidharzstreifen bestehendes Trägerband 6 verwendet.

Das Trägerband 6 weist seitliche Perforationslöcher 7 auf, welche einen einfachen und zuverlässigen Transport des Trägerbandes 6 während der Herstellung der Multi-Chipmodule 4 ermöglichen.

Zunächst werden bei der Fertigung die Bondlöcher 13, 14 durch Bohren oder Stanzen erzeugt und die leitenden Strukturen und/oder Kontaktflächen 15, zum Beispiel in Form einer elektrisch leitenden Folie, die gegebenenfalls nachträglich durch selektives Ätzen oder ähnlichem auf die gewünschte Geometrie reduziert werden kann, aufgebracht. Anschließend wird die leitende Folie einer Veredelung unterzogen.

Auf das wie beschrieben vorbereitete Trägerband werden sodann die Chipgruppen 9, 10 aufgeklebt und durch Bonden mit den leitenden Strukturen und/oder Kontaktflächen 15 elektrisch verbunden. Sowohl Chipgruppe 9 als auch Chipgruppe 10 können einen oder mehrere, übereinander liegende und durch das Bonden miteinander verbunde Chips enthalten.

Um die Chipgruppen 9, 10 vor mechanischer Beschädigung und optischer Analyse zu schützen, werden die Chipgruppen 9, 10 und die Bonddrähte 11, 12 mit einer Abdeckmasse bedeckt, wie beispielsweise einer Moldmasse 8, die durch ihre Steifigkeit dem Multi-Chipmodul 4 zusätzliche Stabilität verleiht. In Fig. 2 ist der Bereich, in dem sich die Moldmasse 8 befindet, durch eine gestrichelte Linie angedeutet. Zu beachten ist hierbei, daß es sich um ein einziges Moldgehäuse handelt, das beide Chipgruppen 9, 10 bedeckt, und nicht wie in früheren Ausführungsformen um zwei separate Moldgehäuse.

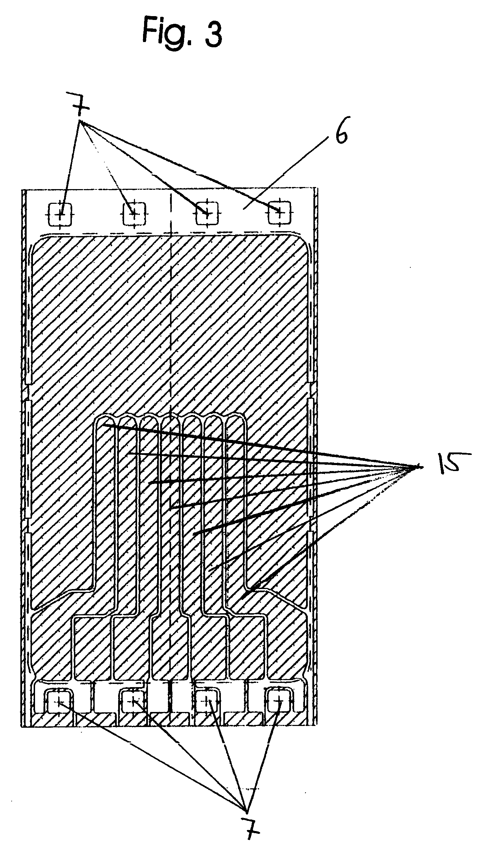

Fig. 3 zeigt im Detail die Kontaktflächenseite des in den Kartenkörper 1 eingebauten Multi-Chipmoduls 4.

Die auf der Kontaktflächenseite des Trägerbandes 6 aufgebrachten leitenden Strukturen sind als Kontaktflächen 15 ausgebildet und so angeordnet, daß die nebeneinander liegenden Chips 9 und 10 parallel geschaltet werden. Die Kontaktflächen 15 sind über Bonddrähte 11, 12 mit entsprechenden Anschlüssen der Chips 9, 10 verbunden, wobei die Bonddrähte jeweils durch die im Trägerband 6 vorgesehenen Bondlöcher verlaufen.

Die Erfindung beschränkt sich in ihrer Ausführung nicht auf das vorstehend angegebene bevorzugte Ausführungsbeispiel. Vielmehr ist eine Anzahl von Varianten denkbar, wie zum Beispiel ein Multi-Chipmodul für den Einbau in kontaktlose Chipkarten, welche von der dargestellten Lösung auch bei grundsätzlich anders gearteten Ausführungen Gebrauch macht.

## Patentansprüche

1. Multi-Chip-Modul, insbesondere zur Implantation in einen Chipkartenkörper (1), mit einem Trägerband und mehreren auf dem Trägerband nebeneinander aufgebrachten Chipgruppen (9), (10), die einen oder mehrere übereinander gestapelte und parallel geschaltete Chips enthalten,
**dadurch gekennzeichnet**, daß Vorrichtungen (15) vorgesehen sind, durch die wenigstens zwei bustaugliche Chipgruppen (9), (10) innerhalb des Multi-Chipmoduls (4) flächig parallel geschaltet werden.

2. Multi-Chip-Modul nach Anspruch 1,
**dadurch gekennzeichnet**, daß es einen Träger (6) umfaßt, der zur Ausbildung der Vorrichtungen mit entsprechenden leitenden Strukturen und/oder Kontaktflächen (15) versehen ist, die die Parallelschaltung der bustauglichen Chipgruppen (9), (10) gewährleisten und vorzugsweise auch zur späteren Kontaktierung der Chips verwendet werden können.

3. Multi-Chip-Modul nach Anspruch 1 oder 2,
**dadurch gekennzeichnet**, daß die leitenden Strukturen und/oder Kontaktflächen (15) unter Verwendung einer elektrisch leitenden Folie erzeugt werden, welche auf das Trägerband aufgebracht wird.

4. Multi-Chip-Modul nach einem der vorhergehenden Ansprüche,
**dadurch gekennzeichnet**, daß die leitenden Strukturen und/oder Kontaktflächen (15) derart angeordnet sind, daß sich das Multi-Chipmodul zum Einbau in kontaktbehaftete Chipkarten eignet.

5. Multi-Chip-Modul nach einem der vorhergehenden Ansprüche,
**dadurch gekennzeichnet**, daß die leitenden Strukturen und/oder Kontaktflächen (15) derart angeordnet sind, daß sich das Multi-Chipmodul zum Einbau in kontaklose Chipkarten eignet.

6. Multi-Chip-Modul nach einem der vorhergehenden Ansprüche,
**dadurch gekennzeichnet**, daß die leitenden Strukturen und/oder Kontaktflächen (15) derart angeordnet sind, daß sich das Multi-Chipmodul zum Einbau in Kombi-Chipkarten eignet.

7. Multi-Chip-Modul nach einem der vorhergehenden Ansprüche,
**dadurch gekennzeichnet**, daß die nebeneinander liegenden und eventuell gestapelten Chips (9), (10) in einem großen Mold-Gehäuse (8) eines 35 mm Epoxyträgers (6) untergebracht sind.
